# EUROPEAN PATENT APPLICATION

(11) **EP 4 776 797 A1**
(43) Date of publication of application: **15.07.2026**
(21) Application number: 24798713.4
(22) Date of filing: 12.10.2024
(51) Int. Cl.: H10F 71/00, H01L 21/67

(54) **METHOD FOR EDGE PASSIVATION AND REPAIR OF CRYSTALLINE SILICON-BASED CELL SEGMENT, AND PASSIVATION APPARATUS**

(30) Priority: 29.07.2024 CN 202411024631
(71) Applicant: Suzhou Xiaoniu Automation Equipment Co., Ltd., Suzhou, Jiangsu 215562 (CN)
(72) Inventor: YANG, Peixi, Suzhou, Jiangsu 215562 (CN); TIAN, Yanghua, Suzhou, Jiangsu 215562 (CN); YONG, Gang, Suzhou, Jiangsu 215562 (CN); YANG, Yong, Suzhou, Jiangsu 215562 (CN); ZHANG, Kun, Suzhou, Jiangsu 215562 (CN); CHEN, Shigeng, Suzhou, Jiangsu 215562 (CN)
(74) Representative: Vitina, Maruta
(86) International application number: PCT/CN2024/124305
(87) International publication number: WO 2026/025638

(57) **Abstract**

A method for edge passivation of crystalline silicon-based shingle cells, in which multiple crystalline silicon-based shingle cells are stacked to form a shingle cell group with cut edges thereof co-planar to form a to-be-passivated surface, and then the shingle cell group is placed in a fixing tooling to form a passivation unit. The passivation unit is conveyed by a conveying mechanism to an evaporation and annealing mechanism. A first source material is evaporated at 20-300°C under vacuum in the evaporation and annealing mechanism to form a first gaseous source material, which is deposited on the to-be-passivated surface to form a first passivation layer. The shingle cell group with the first passivation layer is annealed at 100-350°C. A passivation device for implementing such method is further provided.

## Description

### TECHNICAL FIELD

This application relates to edge passivation of silicon solar cells, and more particularly to a method and device for edge passivation of crystalline silicon-based shingle cells.

### BACKGROUND

The singulation is generally performed by conventional laser scribing-mechanical cleaving (LSMC) technology or thermal laser separation (TLS). If the silicon-based shingle cells (half cells or shingle cells) do not undergo edge passivation, the edge recombination will be exacerbated, thereby attenuating the power conversion efficiency. Regarding the photovoltaic (PV) modules produced from such cells without edge passivation, the sodium ions therein will be gathered at the cut edge under the action of the electric field to form a leakage path when working under a certain system voltage, which will reduce the positive and negative insulation resistance of the PV module, thereby weakening the photoelectric conversion efficiency of the PV module, and attenuating the reliability of the PV module. In the related technology, the edge passivation of silicon-based shingle cells is carried out by chemical deposition, such as Plasma Enhanced Chemical Vapor Deposition (PECVD) method and Atomic Layer Deposition (ALD) method. Specifically, a first layer (a silicon oxide and/or alumina layer) is deposited, then a second layer (a silicon nitride layer) is deposited, and finally, the light-injection hydrogen passivation is carried out to repair the cut damage and to enhance the conversion efficiency of the silicon-based shingle cells. In the above methods, the stacked silicon-based shingle cells are placed into an ALD system and preheated under a vacuum environment, and then the first layer is deposited on the cut edges of the silicon-based shingle cells; then the silicon-based shingle cells are transferred to PECVD equipment and preheated under a vacuum environment, following by injection of an appropriate amount of gas and deposition of the second layer on the cut edges of the silicon-based shingle cells; and finally, the silicon-based shingle cells are placed into a light-injection annealing furnace for hydrogen passivation. In the above passivation process, it is required to treat the silicon-based shingle cells in multiple systems, and there are strict requirements for parameters of individual systems such as temperature, vacuum pressure, gas flow rate, and plasma deposition direction, which makes the passivation process cumbersome, time-consuming and laborious, limiting its industrial application.

### SUMMARY

In view of the deficiencies in the prior art, this application provides a method and device for edge passivation of crystalline silicon-based shingle cells.

Technical solutions of this application are described as follows.

In a first aspect, this application provides a method for edge passivation of crystalline silicon-based shingle cells:
(1) stacking a plurality of crystalline silicon-based shingle cells to form a shingle cell group, wherein cut edges of the plurality of crystalline silicon-based shingle cells are co-planar to form a to-be-passivated surface; and placing the shingle cell group in a fixing tooling to form a passivation unit, wherein the to-be-passivated surface is exposed outside the fixing tooling;
(2) conveying, by a conveying mechanism, the passivation unit to an evaporation and annealing mechanism, wherein the evaporation and annealing mechanism is provided with a first source material; heating and evaporating the first source material at 20-300°C in a vacuum condition in the evaporation and annealing mechanism to form a first gaseous source material; and depositing the first gaseous source material on the to-be-passivated surface to form a first passivation layer; and
(3) subjecting the shingle cell group with the first passivation layer in the passivation unit to annealing treatment at 100-350°C in the evaporation and annealing mechanism.

In an embodiment, the evaporation and annealing mechanism comprises an evaporation chamber and an annealing chamber; the evaporation chamber is not communicated with the annealing chamber; and
step (2) comprises:
(21) conveying, by the conveying mechanism, the passivation unit to the evaporation chamber for deposition of the first passivation layer; and
(22) conveying, by the conveying mechanism, the passivation unit deposited with the first passivation layer to the annealing chamber.

In an embodiment, the evaporation and annealing mechanism is provided with a processing chamber where deposition of the first passivation layer on the passivation unit and the annealing treatment are successively performed.

In an embodiment, step (2) further comprises:
cleaning and drying the to-be-passivated surface before the passivation unit is conveyed to the evaporation and annealing mechanism; or
simultaneously preheating and vacuumizing the evaporation and annealing mechanism at 50-150°C after the passivation unit is conveyed by the conveying mechanism to the evaporation and annealing mechanism.

In an embodiment, the evaporation and annealing mechanism is provided with an electron beam gun; and the electron beam gun is configured to emit an electron beam to bombard the first source material to form the first gaseous source material.

In an embodiment, the evaporation and annealing mechanism is provided with a resistance heating element; and the resistance heating element is configured to carry and heat the first source material to form the first gaseous source material.

In an embodiment, the evaporation and annealing mechanism is provided with a laser emitter; and the laser emitter is configured emit a laser to heat the first source material to form the first gaseous source material.

In an embodiment, the evaporation and annealing mechanism is also provided with a second source material; and
step (2) further comprises:
after the first passivation layer is deposited on the to-be-passivated surface, heating and evaporating, by the evaporation and annealing mechanism, the second source material to form a second gaseous source material; and depositing the second gaseous source material to form a second passivation layer on the first passivation layer.

In an embodiment, the evaporation and annealing mechanism further comprises a first evaporation chamber, a second evaporation chamber, and an annealing chamber which are not communicated with each other; the first source material is provided in the first evaporation chamber; the second source material is provided in the second evaporation chamber; the conveying mechanism is configured to convey the passivation unit deposited with the first passivation layer from the first evaporation chamber to the second evaporation chamber; the second source material is heated and evaporated at 20-300°C in a vacuum condition to form the second gaseous source material; and the second gaseous source material is deposited on the first passivation layer on the to-be-passivated surface to form the second passivation layer; and
the conveying mechanism is further configured to convey the passivation unit on which the first passivation layer and the second passivation layer are deposited to the annealing chamber.

In an embodiment, the evaporation and annealing mechanism is also provided with a second source material; and
step (2) comprises:
heating and evaporating, by the evaporation and annealing mechanism, the second source material at 20-300 °C in a vacuum condition to form a second gaseous source material; and depositing the second gaseous source material on the to-be-passivated surface to form a second passivation layer; and
after the second passivation layer is deposited on the to-be-passivated surface, heating and evaporating, by the evaporation and annealing mechanism, the first source material to form the first gaseous source material, and depositing the first gaseous source material on the second passivation layer to form the first passivation layer.

In an embodiment, in the step (2), the passivation unit is placed in the evaporation and annealing mechanism; an angle between a direction in which the to-be-passivated surface of the passivation unit faces and a gravity direction is 0-90°; the passivation unit is provided above the first source material; and the passivation unit is driven to rotate horizontally during deposition of the first passivation layer on the passivation unit.

In an embodiment, the passivation unit is provided in plurality; the conveying mechanism is configured to convey a plurality of passivation units to the evaporation and annealing mechanism for deposition of the first passivation layer; and the evaporation and annealing mechanism is configured to sequentially deposit the first passivation layer on the plurality of passivation units and perform the annealing treatment.

In an embodiment, in the step (2), the first gaseous source material is deposited at a deposition rate of 0.1-20 Å/s to form the first passivation layer on the to-be-passivated surface.

In a second aspect, this application further provides a passivation device for implementing the above method, comprising:
a stacking mechanism;
a carrying mechanism;
the fixing tooling;
the conveying mechanism; and
the evaporation and annealing mechanism;
the stacking mechanism is configured to stack the plurality of crystalline silicon-based shingle cells to form the shingle cell group; the carrying mechanism is configured to carry the shingle cell group to the fixing tooling to form the passivation unit; and the conveying mechanism is configured to convey the passivation unit to the evaporation and annealing mechanism.

In an embodiment, the fixing tooling comprises a cavity with an opening and a fastener; the cavity is configured to receive the shingle cell group, and make the to-be-passivated surface exposed from the opening or flush with an end face of the opening; the fastener is provided in the cavity; and the fastener is configured to fasten the shingle cell group in the cavity.

In an embodiment, the conveying mechanism comprises a conveying channel and a manipulator; the conveying channel is configured to carry the passivation unit to a discharge end of the conveying channel; and the manipulator is configured to transfer the passivation unit from the discharge end to the evaporation and annealing mechanism.

Compared to the prior art, this application has the following beneficial effects.

On one hand, a method for edge passivation of crystalline silicon-based shingle cells includes the following steps (1)-(3).
(1) A plurality of crystalline silicon-based shingle cells are stacked to form a shingle cell group, and cut edges of the plurality of crystalline silicon-based shingle cells are co-planar to form a to-be-passivated surface. The shingle cell group is placed in a fixing tooling to form a passivation unit. The to-be-passivated surface is exposed outside the fixing tooling 110.
(2) A conveying mechanism 200 conveys the passivation unit 100 to an evaporation and annealing mechanism 300. The evaporation and annealing mechanism 300 is provided with a first source material. The first source material is heated and evaporated at 20-300°C in a vacuum condition in the evaporation and annealing mechanism 300 to form a first gaseous source material. The first gaseous source material is deposited on the to-be-passivated surface to form a first passivation layer.

In the steps (1) and (2), the first gaseous source material is formed by heating and evaporating the first source material by means of physical deposition (i.e., the evaporation coating process). The first gaseous source material is deposited to form the first passivation layer on the to-be-passivated surface in the passivation unit. Compared to chemical deposition (such as ALD method and PECVD method) in which some process factors such as deposition direction of plasma and flow rate of process gas need to be controlled during the deposition process, the evaporation coating process only needs to deposit a first passivation layer by heating and evaporating the first source material to form a first gaseous source material in the vacuum space. Only the vacuum pressure and the evaporation temperature need to be controlled, thereby making the above method with fewer process control factors, simple, and time and labor saving.

Moreover, the chemical deposition has better winding plating capacity, can deposit films on different convex and concave surfaces, and mainly plates the passivation film on the uneven surfaces of silicon wafers after texture surface making. The chemical deposition is applied to deposit the first passivation layer on the cut edges of the crystalline silicon-based shingle cell, which is also prone to lead to the decrease the light illumination area on the front and back sides of the crystalline silicon-based shingle cell due to the blockage of the first passivation layer. Whereas in the physical deposition, the gaseous source material is deposited to form the first passivation layer on the to-be-passivated surface in a manner like light incident deposition, so the obscured area of the crystalline silicon-based shingle cell will not be plated with the first passivation layer.

(3) The evaporation and annealing mechanism anneals the shingle cell group with the first passivation layer in the passivation unit at 100-350 °C.

In this step (3), the interface structure between the first passivation layer and the to-be-passivated surface is changed through the annealing treatment to destroy the Si dangling bond and reduce the chance of the minority carriers on the to-be-passivated surface to meet and composite on the surface, thereby reducing the surface composite rate. Moreover, the free hydrogen atoms in the evaporation and annealing mechanism can occupy the vacancies of the dangling bond on the to-be-passivated surface to reduce the interface density of the surface to reduce the surface composite rate, thereby achieving passivation effect to improve the photoelectric conversion efficiency of the passivated crystalline silicon-based shingle cell.

The above passivation method adopts a physical deposition method, i.e., evaporation deposition and annealing treatment. Compared with the edge passivation method for crystalline silicon-based shingle cells through chemical deposition (including ALD and PECVD), the edge passivation method in this application simplifies the process steps and the corresponding equipment, and has lower requirement for the control of the process factors, so as to improve the photoelectric conversion efficiency of the passivated crystalline silicon-based shingle cells while avoiding the cumbersome process, which facilitates automated and large-scale passivation production of crystalline silicon-based shingle cells. Considering that the ALD and PECVD systems require the introduction of special process gas, and the cell string welding equipment needs to operate under the isolation of the special process gas, the ALD and PECVD systems and the cell string welding equipment cannot be operated in the same workplace, which makes it difficult for the passivation device involving the ALD and PECVD system to be directly connected to the cell string welding equipment. In contrast, the physical deposition used in this application does not require any special process gases, so the relevant equipment in the method described above can be directly connected with the cell string welding equipment, thereby improving the feeding efficiency. On the other hand, this application further provides a passivation device for implementing the above-described edge passivation method. The passivation device includes a stacking mechanism, a carrying mechanism, a fixing tooling, a conveying mechanism, and an evaporation and annealing mechanism. The stacking mechanism is configured to stack the plurality of crystalline silicon-based shingle cells to form the shingle cell group. The carrying mechanism is configured to carry the shingle cell group to the fixing tooling to form the passivation unit. The conveying mechanism is configured to convey the passivation unit to the evaporation and annealing mechanism.

The cooperation among the above stacking mechanism, the carrying mechanism, the fixing tooling, the conveying mechanism, and the evaporation and annealing mechanism realizes the above-described edge passivation method, thereby realizing the automated and large-scale passivation production of the crystalline silicon-based shingle cells.

### BRIEF DESCRIPTION OF THE DRAWINGS

In order to illustrate the embodiments of the present disclosure or the technical solution in the prior art more clearly, the drawings required in the description of the embodiments or the prior art will be briefly described below. Obviously, presented in the drawings are merely some embodiments of the present disclosure, which are not intended to limit the disclosure. For those skilled in the art, other drawings may also be obtained according to the drawings provided herein without paying creative efforts.
Fig. 1 schematically shows a structure of a passivation device according to one embodiment of the present disclosure.
Fig. 2 schematically shows the structure of the passivation device according to another embodiment of the present disclosure.
Fig. 3 schematically shows a structure of a shingle cell group according to one embodiment of the present disclosure.

In the figure: 100, passivation unit; 110, fixing tooling; 120, shingle cell group; 121, crystalline silicon-based shingle cell; 200, conveying mechanism; 210, conveying channel; 220, manipulator; 300, evaporation and annealing mechanism; 310, evaporation chamber; 320, annealing chamber; 400, stacking mechanism; and 500, carrying mechanism.

### DETAILED DESCRIPTION OF EMBODIMENTS

The disclosure will be further described in detail below with reference to the embodiments and accompanying drawings to facilitate the understanding of the present disclosure. Described below are merely preferred embodiments of the disclosure, which are not intended to limit the disclosure. These embodiments are provided to enable comprehensive understanding of the present disclosure.

As used herein, unless otherwise expressly specified and defined, the terms, such as "mount" and "connect", should be understood in a broad sense, for example, it may be fixed connection, detachable connection, or integral connection; it may be direct connection or indirect connection through an intermediate medium; and it may be an internal communication between two members. For those skilled in the art, the specific meanings of the above terms can be understood according to specific situations.

Unless otherwise specified, professional and scientific terms used herein have the same meanings as those familiar to those skilled in the art. Terms used herein in the present disclosure are used only for the purpose of describing specific embodiments and are not intended to limit the disclosure.

This disclosure provides a method for edge passivation of crystalline silicon-based shingle cells, which includes steps (1)-(3).
(1) A plurality of crystalline silicon-based shingle cells 121 are stacked to form a shingle cell group 120, and cut edges of the plurality of crystalline silicon-based shingle cells 121 are co-planar to form a to-be-passivated surface A. The shingle cell group 120 is placed in a fixing tooling 110 to form a passivation unit 100. The to-be-passivated surface A is exposed outside the fixing tooling 110.

In the step (1), the cut edges of the crystalline silicon-based shingle cells 121 are co-planar to form the to-be-passivated surface A. The to-be-passivated surface A is exposed outside the corresponding fixing tooling 110, so as to prevent the winding plating on the cut edge of one of the crystalline silicon-based shingle cells 121 during the deposition of the first passivation layer. The crystalline silicon-based shingle cells 121 may be made of crystalline silicon-based composite perovskite cells, but not limited to it.

(2) The passivation unit 100 is conveyed by a conveying mechanism 200 to an evaporation and annealing mechanism 300. The evaporation and annealing mechanism 300 is provided with a first source material. The first source material is heated and evaporated at 20-300°C in a vacuum condition in the evaporation and annealing mechanism 300 to form a first gaseous source material. The first gaseous source material is deposited on the to-be-passivated surface to form a first passivation layer.

In the steps (1) and (2), the first gaseous source material is formed by evaporating the first source material by means of physical deposition (i.e., the evaporation deposition process). The first gaseous source material is deposited to form the first passivation layer on the to-be-passivated surface in the passivation unit 100. Compared to chemical deposition (such as ALD method and PECVD method) in which some process factors such as deposition direction of plasma and flow rate of process gas need to be controlled during the deposition process, the evaporation coating process only needs to deposit a first passivation layer by heating and evaporating the first source material to form a first gaseous source material in the vacuum space. Only the vacuum pressure and the evaporation temperature need to be controlled, thereby making the above method with fewer process control factors, simple, and time and labor saving. In an embodiment, the first source material may be aluminum oxide or titanium oxide but is not limited it.

Moreover, the chemical deposition has a better winding plating capacity, can deposit films on different convex and concave surfaces, and mainly plates the passivation film on the uneven surfaces of silicon wafers after texture surface making. The chemical deposition is applied to deposit the first passivation layer on the cut edges of the crystalline silicon-based shingle cell 121, which is also prone to lead to the decrease in the light illumination area on the front and back sides of the crystalline silicon-based shingle cell 121 due to the blockage of the first passivation layer. Whereas in the physical deposition, the gaseous source material is deposited to form the first passivation layer on the to-be-passivated surface A in a manner like light incident deposition, so the obscured area of the crystalline silicon-based shingle cell 121 will not be plated with the first passivation layer.

(3) The shingle cell group 120 coated with the first passivation layer in the passivation unit 100 is annealed at 100-350°C in the evaporation and annealing mechanism 300.

In the step (3), the interface structure between the first passivation layer and the to-be-passivated surface A is changed through the annealing treatment to destroy the Si dangling bond and reduce the chance of the minority carriers on the to-be-passivated surface A to meet and composite on the surface, thereby reducing the surface composite rate. Moreover, the free hydrogen atoms in the evaporation and annealing mechanism 300 can occupy the vacancies of the dangling bond on the to-be-passivated surface A to reduce the interface density of the surface to reduce the surface composite rate, thereby achieving passivation effect to improve the photoelectric conversion efficiency of the passivated crystalline silicon-based shingle cell 121.

The above edge passivation method adopts a physical deposition method, i.e., evaporation coating and annealing treatment. Compared with the edge passivation method for crystalline silicon-based shingle cells 121 through chemical deposition (including ALD and PECVD), the edge passivation method in this application simplifies the process steps and the corresponding equipment and reduces the need for controlling the process factors, so as to improve the photoelectric conversion efficiency of the passivated crystalline silicon-based shingle cells 121 while avoiding the cumbersome process, which facilitates automated and large-scale passivation production of crystalline silicon-based shingle cells 121.

Because ALD and PECVD equipment need to pass into the special process gas, the working environment of the battery string welding equipment needs to isolate the special process gas, so the ALD and PECVD equipment and the battery string welding equipment cannot be placed in the same workplace, which causes the ALD and PECVD equipment containing the passivation device more difficult to directly dock the battery string welding equipment. In contrast, the physical deposition used in this application does not require special process gases, so the relevant equipment in the method described above can directly dock with the battery string welding equipment, thereby improving the feeding efficiency of the battery string welding equipment.

In a first embodiment, the evaporation and annealing mechanism 300 includes an evaporation chamber 310 and an annealing chamber 320. The evaporation chamber 310 is not communicated with the annealing chamber 320. In step (2), the conveying mechanism 200 conveys the passivation unit 100 to the evaporation chamber 310 for deposition of the first passivation layer.

In the first embodiment, two workstations for continuous processing are formed by arranging the evaporation chamber 310 and the annealing chamber 320 that are not communicated with each other, so as to continuously perform deposition and annealing treatment of the first passivation layer in the passivation unit 100, thereby further improving the passivation efficiency.

In the first embodiment, in step (2), the conveying mechanism 200 conveys the passivation unit 100 deposited with the first passivation layer to the annealing chamber 320.

In a second embodiment, the evaporation and annealing mechanism 300 is provided with a processing chamber. Deposition of the first passivation layer on the passivation unit 100 and the annealing treatment are successively performed in the processing chamber. In other words, the deposition process and the annealing treatment process of the first passivation layer are both completed in the processing chamber. By completing the deposition process and the annealing treatment process of the first passivation layer of the passivation unit 100 successively in the processing chamber, it not only avoids multiple transfers of the passivation unit 100, but also facilitates the integrated design of the evaporation and annealing mechanism 300.

In a third embodiment, in step (2), before the passivation unit 100 is conveyed to the evaporation and annealing mechanism 300 after the to-be-passivated surface A in the passivation unit 100 is cleaned and dried, or after the conveying mechanism 200 conveys the passivation unit 100 to the evaporation and annealing mechanism 300, and the evaporation and annealing mechanism 300 is simultaneously preheated and vacuumized at 50-100 °C.

Since water stains will remain on the cut edges of the crystalline silicon-based shingle cells 121 when the crystalline silicon-based cell is scribed to form the crystalline silicon-based shingle cells 121. In this step, the cleanliness of the to-be-passivated surface A is improved by cleaning and drying the to-be-passivated surface A in the passivation unit 100. When directly preheating in the evaporation and annealing mechanism 300 at 50-150 °C, water stains on the to-be-passivated surface A will be vaporized on the heating, thereby ensuring the deposition effect of the first passivation layer. Of course, the higher the preheating temperature, the higher the cleaning efficiency of water stains.

In a fourth embodiment, the evaporation and annealing mechanism 300 is provided with an electron beam gun, and the electron beam gun ejects an electron beam to bombard the first source material to form the first gaseous source material.

In the fourth embodiment, the electron beam gun can obtain very high energy density of up to 109 w/cm² and heating temperature of up to 3000-6000 °C. The electron beam gun can accurately use the electron beams to bombard the first source material by utilizing the electromagnetic field. The electron beams not only cause the first source material to rapidly melt and evaporate and then be deposited on the cut edges of the crystalline silicon-based shingle cells 121, but also improve the purity of the first gaseous source material. This facilitates rapid deposition and high purity of the first passivation layer, thereby ensuring the passivation effect.

In a fifth embodiment, the evaporation and annealing mechanism 300 is provided with a resistance heating element. The resistance heating element carries and heats the first source material to form the first gaseous source material.

In a sixth embodiment, the evaporation and annealing mechanism 300 is provided with a laser emitter, and the laser emitter emits a laser to heat the first source material to form the first gaseous source material.

In an embodiment, the evaporation and annealing mechanism 300 is also provided with a second source material. In the step (2), after the first passivation layer is deposited on the to-be-passivated surface A, the evaporation and annealing mechanism 300 heats and evaporates the second source material to form a second gaseous source material. The second gaseous source material is deposited to form a second passivation layer on the first passivation layer. In this step, the second passivation layer is deposited on the first passivation layer to protect the first passivation layer, so as to extend the service life of the first passivation layer, and also to improve the storage time of the crystalline silicon-based shingle cells 121. In this embodiment, the second source material may be aluminum nitride or silicon oxide, but not limited to it.

In this embodiment, the evaporation and annealing mechanism 300 is also provided with the second source material. After the first passivation layer is deposited on the to-be-passivated surface A, the evaporation and annealing mechanism 300 heats and evaporates the second source material to form the second gaseous source material. The second gaseous source material is deposited to form the second passivation layer on the first passivation layer on the to-be-passivated surface A. The evaporation and annealing mechanism 300 includes a first evaporation chamber, a second evaporation chamber, and an annealing chamber 320 that are not communicated with each other. The first source material is provided in the first evaporation chamber, and the second source material is provided in the second evaporation chamber. The conveying mechanism 200 conveys the passivation unit 100 deposited with the first passivation layer from the first evaporation chamber to the second evaporation chamber. The second source material is heated and evaporated in a vacuum condition at 20-300 °C to form a second gaseous source material, and the second gaseous source material deposits the second passivation layer on the first passivation layer on the to-be-passivated surface A.

In this step, the first passivation layer is deposited, the second passivation layer is deposited, and the annealing treatment is carried out sequentially on the to-be-passivated surface A of the passivation unit 100 by setting the first evaporation chamber, the second evaporation chamber, and the annealing chamber 320 to form three consecutive workstations, respectively, thereby facilitating the automated continuous production of the passivation unit 100.

The conveying mechanism 200 further conveys the passivation unit 100 on which the first passivation layer and the second passivation layer are deposited to the annealing chamber 320.

In an embodiment, the evaporation and annealing mechanism 300 is also provided with the second source material. In the step (2), the evaporation and annealing mechanism 300 heats and evaporates the second source material at 20-300 °C in a vacuum condition to form the second gaseous source material. The second gaseous source material is deposited on the to-be-passivated surface A to form the second passivation layer. After the second passivation layer is deposited on the to-be-passivated surface A, the evaporation and annealing mechanism 300 heats and evaporates the first source material to form the first gaseous source material. The first gaseous source material on the second passivation layer is deposited to form the first passivation layer.

In this embodiment, the first gaseous source material is deposited on the second passivation layer on the to-be-passivated surface A. The first gaseous source material is in a free molecular or ionic state in the vapor-deposited state. During the deposition process, the first gaseous source material may be doped in the second passivation layer, and part of the first gaseous source material may pass through the second passivation layer and penetrate into the to-be-passivated surface A, so as to reduce the meeting and compounding probability of minority carriers on the to-be-passivated surface A, thereby reducing the surface compounding rate and achieving a better passivation effect. The second source material may be silicon oxide or titanium oxide, but not limited to it.

In an embodiment, a third source material may also be provided in the evaporation and annealing mechanism 300. After deposition of the first passivation layer, the evaporation and annealing mechanism 300 heats and evaporates the third source material to form a third gaseous source material, which is deposited on the first passivation layer as a protective layer. The third source material may be aluminum nitride or silicon oxide, but is not limited thereto. In an embodiment, in step (2), the passivation unit 100 is placed in the evaporation and annealing mechanism 300. An angle between a direction in which the to-be-passivated surface A of the passivation unit 100 faces and a gravity direction is 0-90°. The passivation unit 100 is provided above the first source material. The passivation unit 100 is driven to rotate horizontally during deposition of the first passivation layer on the passivation unit 100.

In this embodiment, the passivation unit 100 is located above the first source material. The first gaseous source material formed by heating the first source material rises to form a mist. An angle between the direction in which the to-be-passivated surface A of the passivation unit 100 faces and a gravity direction is 0-90°, such as 5°, 10°, 15°, 30°, 60°, 90°, so that the first passivation layer can be deposited on the to-be-passivated surface A more completely, thereby improving deposition effect of the first passivation layer. The passivation unit 100 rotates horizontally so that the to-be-passivated surface A also rotates, and various positions of the to-be-passivated surface A can contact different regional concentrations of the first gaseous source material, so that the first passivation layer deposited on the to-be-passivated surface A can be more uniform.

In an embodiment, the passivation unit 100 is provided in plurality. The conveying mechanism 200 conveys a plurality of passivation units 100 to the evaporation and annealing mechanism 300 to complete the deposition of the first passivation layer. The evaporation and annealing mechanism 300 sequentially deposits the first passivation layer on the plurality of passivation units 100 and performs the annealing treatment. Thus, passivation efficiency is further improved.

In an embodiment, in the step (2), the first gaseous source material is deposited at a deposition rate of 0.1-20 Å/s to form the first passivation layer on the to-be-passivated surface A.

In this embodiment, the deposition rate is 0.1-20 Å/s, and the deposit time for the first gaseous source material to the first passivation layer on the to-be-passivated surface A in the passivation unit 100 is in the range of 60-400 s. Compared to the existing chemical deposition where the process time of the first thin film by the ALD method is in the range of 200-2000 s, and the process time of the second thin film by the PECVD method is in the range of 200-2000s, the coating time of the above steps in this disclosure is shorter, thereby improving the passivation efficiency of the first passivation layer deposited on the to-be-passivated surface A.

### Experimental examples

### Experimental example 1

A plurality of crystalline silicon-based shingle cells 121 were obtained only by thermal laser separation.

### Experimental example 2

A plurality of crystalline silicon-based shingle cells 121 were obtained by thermal laser separation. Firstly, a plurality of crystalline silicon-based shingle cells 121 were stacked to form a shingle cell group 120, and cut edges of the plurality of crystalline silicon-based shingle cells 121 were co-planar to form a to-be-passivated surface A. Then, the shingle cell group 120 was placed in a fixing tooling 110 to form a passivation unit 100. The to-be-passivated surface A was exposed outside the fixing tooling 110. Finally, the passivation unit 100 was conveyed to an evaporation and annealing mechanism 300. The evaporation and annealing mechanism 300 heated and evaporated a first source material at 20-300°C in a vacuum condition to form a first gaseous source material. The first gaseous source material was deposited on the to-be-passivated surface A to form a first passivation layer in the passivation unit 100 to obtain a passivated shingle cell group.

### Experimental example 3

A plurality of crystalline silicon-based shingle cells 121 were obtained by thermal laser separation. Firstly, a plurality of crystalline silicon-based shingle cells 121 were stacked to form a shingle cell group 120, and cut edges of the plurality of crystalline silicon-based shingle cells 121 were co-planar to form a to-be-passivated surface A. The shingle cell group 120 was placed in a fixing tooling 110 to form a passivation unit 100. The to-be-passivated surface A of the shingle cell group 120 was exposed outside the fixing tooling 110. Then, the passivation unit 100 was conveyed to an evaporation and annealing mechanism 300. The evaporation and annealing mechanism 300 heated and evaporated a first source material at 20-300°C in a vacuum condition to form a first gaseous source material. The first gaseous source material was deposited on the to-be-passivated surface A to form a first passivation layer in the passivation unit 100. The evaporation and annealing mechanism 300 annealed the deposited shingle cell group with the first passivation layer in the passivation unit 100 at 100-350°C, thereby obtaining a passivated shingle cell group.

### Comparative example 1

A plurality of crystalline silicon-based shingle cells 121 were obtained by thermal laser separation. Firstly, a plurality of crystalline silicon-based shingle cells 121 were stacked to form a shingle cell group 120, and cut edges of the plurality of crystalline silicon-based shingle cells 121 were co-planar to form a to-be-passivated surface A. The shingle cell group 120 was placed in a fixing tooling 110 to form a passivation unit 100. The to-be-passivated surface A of the shingle cell group 120 was exposed outside the fixing tooling 110. Then, the passivation unit 100 was conveyed to an ALD device to deposit a first passivation film on the to-be-passivated surface A. Next, the passivation unit 100 was conveyed to a PECVD device to deposit a second protective film. Finally, the passivation unit 100 was conveyed to a light-injection annealing furnace for an annealing treatment, thereby obtaining a passivated shingle cell group.

In the Experimental examples 1-3 and Comparative example 1, the crystalline silicon-based shingle cells 121 were obtained by the thermal laser separation from a crystalline silicon-based cell of 182 mm×182 mm. The performance of three crystalline silicon-based shingle cells 121, which were randomly selected from the Experimental example 1 and the passivated shingle cell groups obtained in the Experimental examples 2-3 and Comparative example 1, were characterized.

The halm I-V tester was used for performance characterization. Each crystalline silicon-based shingle cell 121 selected from Experimental examples 1-3 and Comparative example 1 were tested at 25±2°C, light intensity amplitude of 1000±50W/m². The test results were shown in the table below.

| | Voc(mv) | Isc(A) | Vm(mv) | Im(A) | Pₘₐₓ(W) | Eff(%) |
|---|---|---|---|---|---|---|
| Experimental example 1 | 0.72 | 6.482 | 0.613 | 6.575 | 4.03 | 24.335 |
| | 0.717 | 6.447 | 0.612 | 6.563 | 4.017 | 24.251 |
| | 0.717 | 6.458 | 0.614 | 6.541 | 4.016 | 24.249 |
| Experimental example 2 | 0.724 | 6.475 | 0.616 | 6.558 | 4.04 | 24.392 |
| | 0.718 | 6.448 | 0.620 | 6.515 | 4.039 | 24.389 |
| | 0.72 | 6.456 | 0.620 | 6.521 | 4.043 | 24.411 |
| Experimental | 0.724 | 6.493 | 0.617 | 6.566 | 4.051 | 24.461 |
| example 3 | 0.718 | 6.468 | 0.619 | 6.545 | 4.051 | 24.462 |
| | 0.719 | 6.468 | 0.619 | 6.551 | 4.055 | 24.484 |
| Comparative example 1 | 0.717 | 6.474 | 0.618 | 6.554 | 4.05 | 24.456 |
| | 0.720 | 6.471 | 0.619 | 6.549 | 4.054 | 24.476 |
| | 0.723 | 6.482 | 0.617 | 6.563 | 4.045 | 24.45 |

In the above table, Voc represents open-circuit voltage; Isc represents short-circuit current; Pₘₐₓ represents peak power; Im represents the operating current; and Vm represents the peak voltage; and Eff represents conversion efficiency.

As shown in the above table, by comparing the average conversion efficiency of the three passivated shingle cell samples in Experimental Example 2 with the average conversion efficiency of three shingle samples in Experimental Example 1, it could be seen that compared to the crystalline silicon-based shingle cells 121 that were obtained only by the thermal laser separation, the conversion efficiency of the passivated crystalline silicon-based shingle cells, that only deposited with the first passivation layer by the evaporation and annealing mechanism 300 under vacuum conditions and at 20-300 °C, was increased by about 0.12%.

By comparing the average conversion efficiency of the three passivated shingle cell samples in Experiment Example 3 with the average conversion efficiency of the three shingle cell samples in Experiment Example 1, it could be seen that compared to the crystalline silicon-based shingle cells that was obtained only by the thermal laser separation, the conversion efficiency of the crystalline silicon-based shingle cells obtained by the method in Experiment Example 3 was increased by about 0.19%.

By comparing the average conversion efficiency of the three passivated shingle cell samples in Experiment Example 3 with the average conversion efficiency of the three passivated shingle cell samples in Experiment Example 2, it could be seen that compared to the crystalline silicon-based shingle cells obtained only by the evaporative coating process, the conversion efficiency of the crystalline silicon-based shingle cells obtained by the evaporative coating and annealing processes in sequence was increased by about 0.07%.

By comparing the average conversion efficiency of the three passivated shingle cell samples in Comparative example 1 with the average conversion efficiency of the three shingle cell samples in Experimental Example 1, it could be seen that compared to the crystalline silicon-based shingle cells that was obtained only by the laser non-destructive method, the passivated crystalline silicon-based shingle cells obtained by the method in the Comparative example 1 was increased by about 0.18%.

By comparing the average conversion efficiency of the three passivated shingle cell samples in Comparative example 1 with the average conversion efficiency of the three shingle cell samples in Experimental Example 3, it could be seen that the conversion efficiency of Experimental Example 3 was similar to that of Comparative example 1. The results indicated that the passivation effect achieved by physical deposition was basically the same as the passivation effect achieved by chemical deposition. The physical deposition had a simpler process. Moreover, the chemical deposition will easily cause winding plating, mainly because the arc ion plating had better winding plating capability, and could deposit films on polymer substrates with different convex and concave surfaces. The arc ion plating was particularly suitable for coating on samples with uneven surfaces, which was also prone to lead to the decrease the light illumination area on the front and back sides of the crystalline silicon-based shingle cell due to the blockage of the first passivation layer. Whereas in the physical deposition, the gaseous source material was deposited to form the first passivation layer on the to-be-passivated surface in a manner like light incident deposition, so the obscured area of the crystalline silicon-based shingle cell would not be plated with the first passivation layer.

The above-described edge passivation method in the disclosure could repair the cut edges of crystalline silicon-based shingle cells and improve the conversion efficiency. Moreover, compared to the chemical deposition method, while achieving the same purpose of improving the efficiency, the edge passivation method in the disclosure were simple, had fewer process control factors, were time-saving and labor-saving, and facilitated large-scale passivation production of the crystalline silicon-based shingle cells.

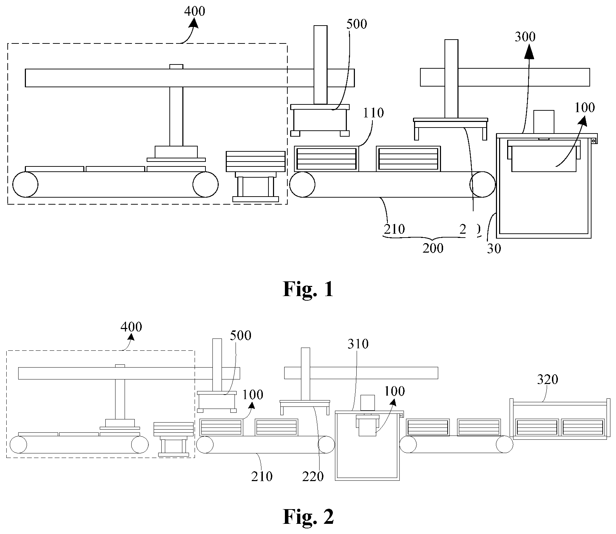

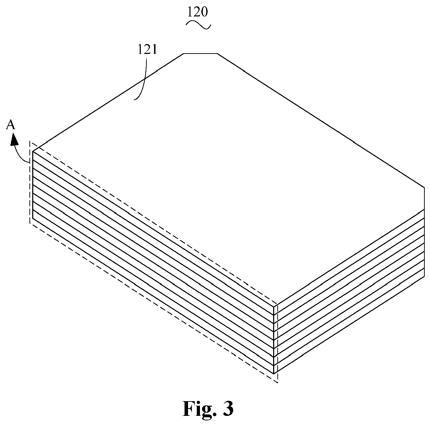

As shown in Figs. 1-2, a passivation device for implementing the above-described edge passivation method is further provided. The passivation device includes the stacking mechanism 400, the carrying mechanism 500, the fixing tooling 110, the conveying mechanism 200, and the evaporation and annealing mechanism 300. The stacking mechanism 400 is configured to stack a plurality of crystalline silicon-based shingle cells 121 to form the shingle cell group 120 (as shown in Fig. 3). The carrying mechanism 500 is configured to for carry the shingle cell group 120 to the fixing tooling 110 to form the passivation unit 100. The conveying mechanism 200 is configured to carry and drive the fixing tooling 110 the passivation unit 100 to the evaporation and annealing mechanism 300. Through the cooperation among the stacking mechanism 400, the carrying mechanism 500, the fixing tooling 110, the conveying mechanism 200, and the evaporation and annealing mechanism 300, the above-described edge passivation method can be implemented, thereby facilitating the automated and large-scale passivation production of the crystalline silicon-based shingle cells 121.

In addition, the stacking mechanism 400 may be a stacking storage manipulator that can be lifted and lowered stepwise. Each time the stacking of one crystalline silicon-based shingle cell 121 is completed, the stacking storage manipulator will descend by the height of one crystalline silicon-based shingle cell 121 (i.e., the thickness of one crystalline silicon-based shingle cell) to enable consistent operation among the crystalline silicon-based shingle cells 121. In another embodiment, the stacking mechanism 400 includes a belt channel, a gripping manipulator, and a stacking table. The belt channel carries a plurality of crystalline silicon-based shingle cells 121 in an array form. The gripping manipulator can grasp and stack the crystalline silicon-based shingle cells 121 onto the stacking table, but not limited to it.

In an embodiment, the fixing tooling 110 includes a cavity with an opening and a fastener. The cavity is configured to receive the shingle cell group 120, and make the to-be-passivated surface A exposed from the opening or flush with an end face of the opening. The fastener is provided in the cavity; and the fastener is configured to fasten the shingle cell group 120 in the cavity, thereby avoiding relative displacement of a plurality of crystalline silicon-based shingle cells 121 that may cause at least one of a plurality of crystalline silicon-based shingle cells 121 to winding plating during the deposition process of the first passivation layer.

In an embodiment, the conveying mechanism 200 includes a conveying channel 210 and a manipulator 220. The conveying channel 210 is configured to carry the passivation unit 100 to a discharge end of the conveying channel 210. The manipulator 220 is configured to transfer the passivation unit 100 from the discharge end to the evaporation and annealing mechanism 300.

Described above are merely preferred embodiments of the disclosure, which are not intended to limit the disclosure. It should be understood that any modifications and replacements made by those skilled in the art without departing from the spirit of the disclosure should fall within the scope of the disclosure defined by the appended claims.

## Claims

1. A method for edge passivation of crystalline silicon-based shingle cells, comprising:
(1) stacking a plurality of crystalline silicon-based shingle cells (121) to form a shingle cell group (120), wherein cut edges of the plurality of crystalline silicon-based shingle cells (121) are co-planar to form a to-be-passivated surface; and placing the shingle cell group (120) in a fixing tooling (110) to form a passivation unit (100), wherein the to-be-passivated surface is exposed outside the fixing tooling (110);
(2) conveying, by a conveying mechanism (200), the passivation unit (100) to an evaporation and annealing mechanism (300), wherein the evaporation and annealing mechanism (300) is provided with a first source material; heating and evaporating the first source material at 20-300°C in a vacuum condition in the evaporation and annealing mechanism (300) to form a first gaseous source material; and depositing the first gaseous source material on the to-be-passivated surface to form a first passivation layer; and
(3) subjecting the shingle cell group (120) with the first passivation layer in the passivation unit (100) to annealing treatment at 100-350°C in the evaporation and annealing mechanism (300).

2. The method of claim 1, **characterized in that** the evaporation and annealing mechanism (300) comprises an evaporation chamber (310) and an annealing chamber (320); the evaporation chamber (310) is not communicated with the annealing chamber (320); and
step (2) comprises:
(21) conveying, by the conveying mechanism (200), the passivation unit (100) to the evaporation chamber (310) for deposition of the first passivation layer; and
(22) conveying, by the conveying mechanism (200), the passivation unit (100) deposited with the first passivation layer to the annealing chamber (320).

3. The method of claim 1, **characterized in that** the evaporation and annealing mechanism (300) is provided with a processing chamber where deposition of the first passivation layer on the passivation unit (100) and the annealing treatment are successively performed.

4. The method of claim 1, **characterized in that** step (2) further comprises:
cleaning and drying the to-be-passivated surface before the passivation unit (100) is conveyed to the evaporation and annealing mechanism (300); or
simultaneously preheating and vacuumizing the evaporation and annealing mechanism (300) at 50-150°C after the passivation unit (100) is conveyed by the conveying mechanism (200) to the evaporation and annealing mechanism (300).

5. The method of claim 1, **characterized in that** the evaporation and annealing mechanism (300) is provided with an electron beam gun; and the electron beam gun is configured to emit an electron beam to bombard the first source material to form the first gaseous source material.

6. The method of claim 1, **characterized in that** the evaporation and annealing mechanism (300) is provided with a resistance heating element; and the resistance heating element is configured to carry and heat the first source material to form the first gaseous source material.

7. The method of claim 1, **characterized in that** the evaporation and annealing mechanism (300) is provided with a laser emitter; and the laser emitter is configured emit a laser to heat the first source material to form the first gaseous source material.

8. The method of claim 1, **characterized in that** the evaporation and annealing mechanism (300) is also provided with a second source material; and
step (2) further comprises:
after the first passivation layer is deposited on the to-be-passivated surface, heating and evaporating, by the evaporation and annealing mechanism (300), the second source material to form a second gaseous source material; and depositing the second gaseous source material to form a second passivation layer on the first passivation layer.

9. The method of claim 8, **characterized in that** the evaporation and annealing mechanism (300) further comprises a first evaporation chamber, a second evaporation chamber, and an annealing chamber (320) which are not communicated with each other; the first source material is provided in the first evaporation chamber; the second source material is provided in the second evaporation chamber; the conveying mechanism (200) is configured to convey the passivation unit (100) deposited with the first passivation layer from the first evaporation chamber to the second evaporation chamber; the second source material is heated and evaporated at 20-300°C in a vacuum condition to form the second gaseous source material; and the second gaseous source material is deposited on the first passivation layer on the to-be-passivated surface to form the second passivation layer; and
the conveying mechanism (200) is further configured to convey the passivation unit (100) on which the first passivation layer and the second passivation layer are deposited to the annealing chamber (320).

10. The method of claim 1, **characterized in that** the evaporation and annealing mechanism (300) is also provided with a second source material; and
step (2) comprises:
heating and evaporating, by the evaporation and annealing mechanism (300), the second source material at 20-300 °C in a vacuum condition to form a second gaseous source material; and depositing the second gaseous source material on the to-be-passivated surface to form a second passivation layer; and
after the second passivation layer is deposited on the to-be-passivated surface, heating and evaporating, by the evaporation and annealing mechanism (300), the first source material to form the first gaseous source material, and depositing the first gaseous source material on the second passivation layer to form the first passivation layer.

11. The method of claim 1, **characterized in that** in the step (2), the passivation unit (100) is placed in the evaporation and annealing mechanism (300); an angle between a direction in which the to-be-passivated surface of the passivation unit (100) faces and a gravity direction is 0-90°; the passivation unit (100) is provided above the first source material; and the passivation unit (100) is driven to rotate horizontally during deposition of the first passivation layer on the passivation unit (100).

12. The method of claim 1, **characterized in that** the passivation unit (100) is provided in plurality; and the evaporation and annealing mechanism (300) is configured to sequentially deposit the first passivation layer on a plurality of passivation units (100) and perform the annealing treatment.

13. The method of claim 1, **characterized in that** in the step (2), the first gaseous source material is deposited at a deposition rate of 0.1-20 Å/s to form the first passivation layer on the to-be-passivated surface.

14. A passivation device for implementing the method of any one of claims 1-13, comprising:
a stacking mechanism (400);
a carrying mechanism (500);
the fixing tooling (110);
the conveying mechanism (200); and
the evaporation and annealing mechanism (300);
**characterized in that** the stacking mechanism (400) is configured to stack the plurality of crystalline silicon-based shingle cells (121) to form the shingle cell group (120); the carrying mechanism (500) is configured to carry the shingle cell group (120) to the fixing tooling (110) to form the passivation unit (100); and the conveying mechanism (200) is configured to convey the passivation unit (100) to the evaporation and annealing mechanism (300).

15. The passivation device of claim 14, **characterized in that** the fixing tooling (110) comprises a cavity with an opening and a fastener; the cavity is configured to receive the shingle cell group (120), and make the to-be-passivated surface exposed from the opening or flush with an end face of the opening; the fastener is provided in the cavity; and the fastener is configured to fasten the shingle cell group (120) in the cavity.

16. The passivation device of claim 14, **characterized in that** the conveying mechanism (200) comprises a conveying channel (210) and a manipulator (220); the conveying channel (210) is configured to carry the passivation unit (100) to a discharge end of the conveying channel (210); and the manipulator (220) is configured to transfer the passivation unit (110) from the discharge end to the evaporation and annealing mechanism (300).
